# EUROPEAN PATENT APPLICATION

(11) **EP 4 071 269 A1**
(43) Date of publication of application: **12.10.2022**
(21) Application number: 20895948.6
(22) Date of filing: 24.04.2020
(51) Int. Cl.: C23C 16/505, C23C 16/515, C23C 16/458, C23C 16/455, C23C 16/26

(54) **COATING EQUIPMENT**

(30) Priority: 04.12.2019 CN 201911228777; 04.12.2019 CN 201922152448 U; 04.12.2019 CN 201922153851 U; 04.12.2019 CN 201922151833 U
(71) Applicant: Jiangsu Favored Nanotechnology Co., Ltd., Yuqi Industry Park, Huishan District Wuxi Jiangsu 214000 (CN)
(72) Inventor: ZONG, Jian, Wuxi, Jiangsu 214112 (CN); LAN, Zhuyao, Wuxi, Jiangsu 214112 (CN); SHAN, Wei, Wuxi, Jiangsu 214112 (CN); HAN, Hui, Wuxi, Jiangsu 214112 (CN)
(74) Representative: Mewburn Ellis LLP
(86) International application number: PCT/CN2020/086526
(87) International publication number: WO 2021/109425

(57) **Abstract**

Provided by the present invention is a coating equipment. The coating equipment comprises a reaction cavity body, a gas supply part, a vacuum pumping apparatus, a pulse power supply and a radio frequency power supply, wherein the reaction cavity body has a reaction cavity, the gas supply part is used to supply gas to the reaction cavity, the vacuum pumping apparatus is connected with the reaction cavity body in a manner capable of communication with the reaction cavity, the pulse power supply is used to provide the reaction cavity body with a pulsed electric field, and the radio frequency power supply is used to provide the reaction cavity body with a radio frequency electric field. A plurality of coated workpieces are held in the reaction cavity, and when the pulse power supply and the radio frequency power supply are connected, the gas in the reaction cavity body is ionized under the action of the radio frequency electric field and the pulsed electric field to generate plasma, and the plasma is deposited to the surface of workpieces to be coated.

## Description

### TECHNICAL FIELD

The present disclosure relates to the coating field, and more particularly, to a coating equipment.

### BACKGROUND

Coating technology is an effective means to improve the surface performance of materials. It can enhance the strength, scratch resistance, wear resistance, heat dissipation, water resistance, corrosion resistance or reduce the friction of the surface of the workpiece by forming a film layer on the surface of the workpiece.

According to the current market demand, the application of coating technology in the field of electronic product protection has attracted more and more attention. There are various electronic products to be coated, such as PCB circuit board, electronic devices, mobile phone, keyboard, and computer. The annual global shipment of mobile phones reaches more than 1.5 billion, and coating technology has been widely applied in the protection of components such as PCB main boards, PCB sub boards, charging ports, TF card interface ports, earphone jacks, and screens of mobile phones. Generally speaking, it is not only required that the film layer formed on mobile phones to have the function of enhancing the wear resistance and strength of the mobile phone surface, but also have high light transmittance. The functional characteristics of the film layer largely depend on coating equipment and process technology.

At present, the coating technology mainly adopts the vacuum vapor deposition method which mainly includes physical vapor deposition (PVD) and chemical vapor deposition (CVD). Physical vapor deposition mainly includes vacuum evaporation coating, sputtering coating, and ion coating. According to the activation method for raw materials, chemical vapor deposition can be classified into thermal CVD, plasma CVD, laser CVD, ultraviolet CVD, etc.

Plasma enhanced chemical vapor deposition (PECVD) coating technology which has many characteristics such as low deposition temperature and high deposition rate is another common technical means to prepare coatings. Plasma enhanced chemical vapor deposition technology uses the high-energy electrons in plasma to activate gas molecules, to increase free radical generation and promote ionization, to generate many active particles such as high-energy particles, atomic or molecular ions and electrons with strong chemical activity. The active particles react to form reaction products. Since the high-energy electrons provide energy for the raw material particles, chemical vapor deposition can occur without more external heat energy, which means the reaction temperature is low. Therefore, chemical reacting that are difficult or slow to occur is available.

Chinese patent application CN203411606U discloses a coating equipment, which uses plasma enhanced chemical vapor deposition coating technology to form a coating. It is provided with a plurality of chambers with at least one chamber being used for buffering before coating, with at least one chamber being used for coating, and with at least one chamber being used for post-coating cooling buffering. Obviously, the structure of such a coating equipment is complicated, for example, a control valve needs to be provided between independent chambers, and an additional device for transmitting workpieces between multiple chambers is required. In the event that a failure happens during production, the difficulty and cost of maintenance is high due to the application of multiple chambers.

Therefore, there is a need to provide a coating equipment with a simple structure and suitable for mass production of film layers.

### SUMMARY

An advantage of the present disclosure is to provide a coating equipment, wherein the coating equipment is suitable for industrial application.

Another advantage of the present disclosure is to provide a coating equipment, wherein the coating equipment can be used to coat a number of workpieces simultaneously.

Another advantage of the present disclosure is to provide a coating equipment, wherein the coating equipment can be used to etch and activate a surface of a workpiece, so as to facilitate the preparation of a film layer on the surface of a workpiece.

Another advantage of the present disclosure is to provide a coating equipment, wherein the coating equipment can be used to coat a workpiece with an organic film.

Another advantage of the present disclosure is to provide a coating equipment, wherein the coating equipment can be used to coat a workpiece with an inorganic film.

Another advantage of the present disclosure is to provide a coating equipment, wherein the coating equipment can be used to coat workpiece with different types.

Another advantage of the present disclosure is to provide a coating equipment, wherein the coating equipment can be used to coat a workpiece in a low temperature environment to avoid damages to the workpiece.

According to an aspect of the present disclosure, the present disclosure provides a coating equipment for coating at least one workpiece, wherein the coating equipment includes: a reaction chamber body provided with a reaction chamber; a gas supply part configured to supply gas to the reaction chamber; a pumping device configured to communicate with the reaction chamber; and a pulse power supply adapted to provide the reaction chamber body with a pulsed electric field, wherein the reaction chamber is adapted to accommodate a plurality of workpiece, when the pulse power supply is turned on, the gas in the reaction chamber body is ionized under the pulsed electric field to generate plasma to deposit on the surface of a workpiece.

According to at least one embodiment of the present disclosure, the coating equipment further includes a radio frequency power supply adapted to provide the reaction chamber body with a radio frequency electric field, wherein when the radio frequency power supply is turned on, the plasma is deposited on the surface of the workpiece under the pulsed electric field and the radio frequency electric field.

According to at least one embodiment of the present disclosure, at least one electrode is configured on the other side of the workpiece as a cathode of the pulse power supply to form the pulsed electric field.

According to at least one embodiment of the present disclosure, at least one electrode is configured in the reaction chamber body as an anode of the pulse power supply.

According to at least one embodiment of the present disclosure, the coating equipment further includes a multi-layered support, including a plurality of support parts which are configured in the reaction chamber at a preset spacing, wherein a plurality of workpieces are respectively supported by the plurality of support parts, and the electrode serving as the cathode of the pulse power supply is configured on at least one support part.

According to at least one embodiment of the present disclosure, the coating equipment further includes a multi-layered support, including a plurality of support parts, a plurality of workpieces are respectively supported by the plurality of support parts, and at least one support part serves as a cathode of the pulse power supply.

According to at least one embodiment of the present disclosure, at least one electrode is configured on a support part as an electrode of the radio frequency power supply.

According to at least one embodiment of the present disclosure, at least one electrode is configured on a support part as an anode of the pulse power supply.

According to at least one embodiment of the present disclosure, the electrode of the radio frequency power supply is configured above a workpiece and the workpiece is supported by a support part serving as the cathode of the pulse power supply.

According to at least one embodiment of the present disclosure, the support part serving as the cathode of the pulse power supply and the support part serving as the anode of the pulse power supply are alternately configured.

According to at least one embodiment of the present disclosure, positive ions in the plasma ionized by the radio frequency electric field can move from top to bottom toward a workpiece and deposit on the surface of the workpiece.

According to at least one embodiment of the present disclosure, at least one layer of the multi-layered support serves as a gas supply part, and the support part serving as the gas supply part is configured above a workpiece.

According to at least one embodiment of the present disclosure, the support part serving as the gas supply part includes a top plate and a bottom plate, and a space is configured between the top plate and the bottom plate for temporarily storing gas, and at least one gas outlet is configured on the bottom plate, so that gas can get out of the upper position above the workpiece.

According to at least one embodiment of the present disclosure, the support part serving as the gas supply part and the support part serving as the cathode of the pulse power supply are alternately configured.

According to at least one embodiment of the present disclosure, the at least one gas outlet is evenly configured above the workpiece.

According to at least one embodiment of the present disclosure, the support part serving as the gas supply part is electrically coupled with the radio frequency power supply.

According to at least one embodiment of the present disclosure, the multi-layered support is configured in the reaction chamber body in a manner of being removable, the multi-layered support further includes at least two upright posts, and the support parts are configured on the at least two upright posts at a preset spacing.

According to at least one embodiment of the present disclosure, the multi-layered support further includes at least one insulating part, the insulating part is configured at the bottom end of an upright post to insulate the multi-layered support from the reaction chamber body.

According to at least one embodiment of the present disclosure, the multi-layered support is detachably supported on the reaction chamber body.

According to at least one embodiment of the present disclosure, the support parts are configured in the reaction chamber body in parallel with each other.

According to at least one embodiment of the present disclosure, the coating voltage of the pulse power supply is controlled to be in a range of -300 V to -3500 V, and the frequency of the pulse power supply ranges from 20 KHz to 360 KHz.

According to at least one embodiment of the present disclosure, the duty ratio of the pulse power supply ranges from 5% to 100%.

According to at least one embodiment of the present disclosure, the vacuum degree of the coating equipment before coating is controlled to be no more than 2 × 10⁻³Pa.

According to at least one embodiment of the present disclosure, the vacuum degree of the coating equipment during the coating process ranges from 0.1Pa to 20Pa.

According to an aspect of the present disclosure, the present disclosure provides a coating equipment for coating at least one workpiece, wherein the coating equipment includes: a reaction chamber body provided with a reaction chamber; a gas supply part configured to supply gas to the reaction chamber; a feeding device configured to communicate with the reaction chamber; a pumping device configured to communicate with the reaction chamber, wherein the pumping device is configured to pump the gas in the reaction chamber to control the vacuum degree; and a pulse power supply adapted to provide the reaction chamber body with a pulsed electric field, wherein the reaction chamber is adapted to accommodate a plurality of workpieces, when the pulse power supply is turned on, the gas in the reaction chamber body is ionized under the pulsed electric field to generate plasma, and the plasma is deposited on the surface of a workpiece.

An aspect of the present disclosure provides a coating equipment for coating at least one workpiece, wherein the coating equipment includes: a reaction chamber device provided with a reaction chamber; a gas supply part, wherein the gas supply part is configured to supply gas to the reaction chamber; a pulse power supply adapted to provide the reaction chamber device with a pulsed electric field; and a support, at least a part of the support being electrically coupled with the pulse power supply as a cathode, wherein the support is adapted to hold the workpiece, and when the pulse power supply is turned on, the gas supplied by the gas supply part for the reaction chamber device generates plasma under the action of ionization, and positive ions in the plasma are deposited toward the surface of the workpiece under the pulsed electric field.

An aspect of the present disclosure provides a coating equipment for coating at least one workpiece, wherein the coating equipment includes: a reaction chamber device provided with a reaction chamber; a discharge device configured to provide an electric field to the reaction chamber device; a gas supply part configured to supply gas to the reaction chamber device; and a multi-layered support, including a plurality of support parts which are configured in the reaction chamber at a preset spacing, at least a part of the gas supply part is configured on at least one support part, and the at least one support part is provided with at least one gas outlet for gas getting out.

### BRIEF DESCRIPTION OF THE DRAWINGS

FIG. 1 is a schematic diagram of a coating equipment according to an embodiment of the present disclosure;
FIG. 2 is a schematic diagram of the coating equipment from another view according to the above embodiment of the present disclosure;
FIG. 3 is a schematic diagram of a reaction chamber body and a support device of the coating equipment according to the above embodiment of the present disclosure;
FIG. 4 is a schematic diagram of another reaction chamber body and another support device of the coating equipment of another embodiment according to the above embodiment of the present disclosure;
FIG. 5 is a schematic diagram of another reaction chamber body and another support device of the coating equipment of another embodiment according to the above embodiment of the present disclosure;
FIG. 6 is a schematic diagram of another reaction chamber body and another support device of the coating equipment of another embodiment according to the above embodiment of the present disclosure;
FIG. 7 is a schematic diagram of another reaction chamber body and another support device of the coating equipment of another embodiment according to the above embodiment of the present disclosure; and
FIG. 8 is a schematic diagram of another reaction chamber body and another support device of the coating equipment of another embodiment according to the above embodiment of the present disclosure.

### DETAILED DESCRIPTION

The following description serves to disclose the disclosure to enable those skilled in the art to practice the present disclosure. The embodiments in the following description are only for examplification. Those skilled in the art may think of other obvious variations. The basic principles of the present disclosure as defined in the following description may be applied to other embodiments, variations, modifications, equivalents, and other technical solutions without departing from the spirit and scope of the present disclosure.

Those skilled in the art will appreciate that, in the disclosure of the present disclosure, the terms "longitudinal", "transverse", "upper", "lower", "front", "rear", "left", "right", "vertical", "horizontal", "top", "bottom", "inner", "outer" and the like indicate azimuth or positional relationships based on the azimuth or positional relationships shown in the drawings. It is only intended to facilitate the description and simplify the description, and not to indicate or imply that the apparatus or element referred to must have a particular orientation, be constructed and operated in a particular orientation, so the above-mentioned terms are not to be construed to limit the present disclosure.

It will be appreciated that the term "a", "an", or "one" is to be understood as "at least one" or "one or more", i.e., in one embodiment, the number of one element may be one and in another embodiment the number of one element may be multiple, and that the term "a", "an", or "one" is not to be construed to limit the number.

The present disclosure provides a coating equipment which can be used to prepare various types of films, such as diamond-like carbon films (DLC films) and organic films. The coating equipment is used to form a film layer by chemical deposition on a surface of a workpiece by a plasma enhanced chemical vapor deposition (PECVD) technology. Specifically, a reaction chamber body of the coating equipment is adapted for accommodating a workpiece, and a film layer is formed on the surface of the workpiece by plasma enhanced chemical vapor deposition.

The plasma enhanced chemical vapor deposition (PECVD) process has many advantages over other existing deposition processes: (1) dry deposition does not need to use organic solvents; (2) an etching effect of the plasma on the surface of the substrate makes a deposited film have good adhesion with the substrate; (3) the film can be deposited evenly on the surface of an irregular substrate with strong vapor permeability; (4) the coating has good designability, and compared with a micron-level control accuracy of the liquid-phase method, the chemical vapor method can control a thickness of the coating in nano scale; (5) the coating has simple structure, the chemical vapor method uses plasma activation, and does not need to design a specific initiator to initiate composite coatings of different materials, and a variety of raw materials can be combined through adjusting input energy; (6) good compactness can be achieved, and the chemical vapor deposition method often activates multiple active sites in a process of plasma initiation, which is similar to the condition in which a molecule has multiple functional groups in solution reaction, and a cross-linked structure is formed between molecular chains through multiple functional groups; (7) as a coating treatment technology, it has excellent universality and wide selection range of coating objects and raw materials used for coating.

The present disclosure provides a coating equipment. Uniform film layer can be obtained on the workpieces in batch by the coating equipment. A pulse power supply can generate a strong electric field during the discharge process, and the active particles in a high-energy state can be accelerated and deposited on the surface of the workpiece by the strong electric field, so as to facilitate the formation of a firm film.

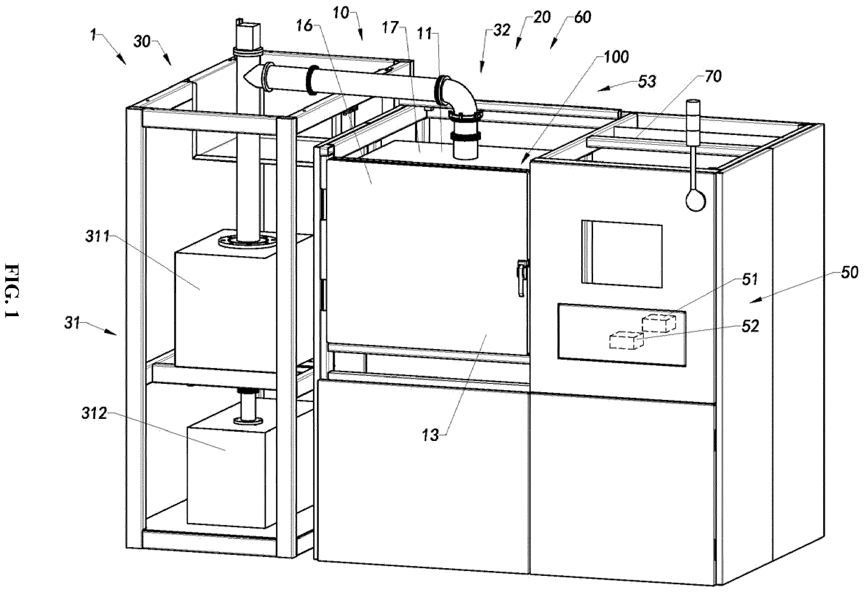

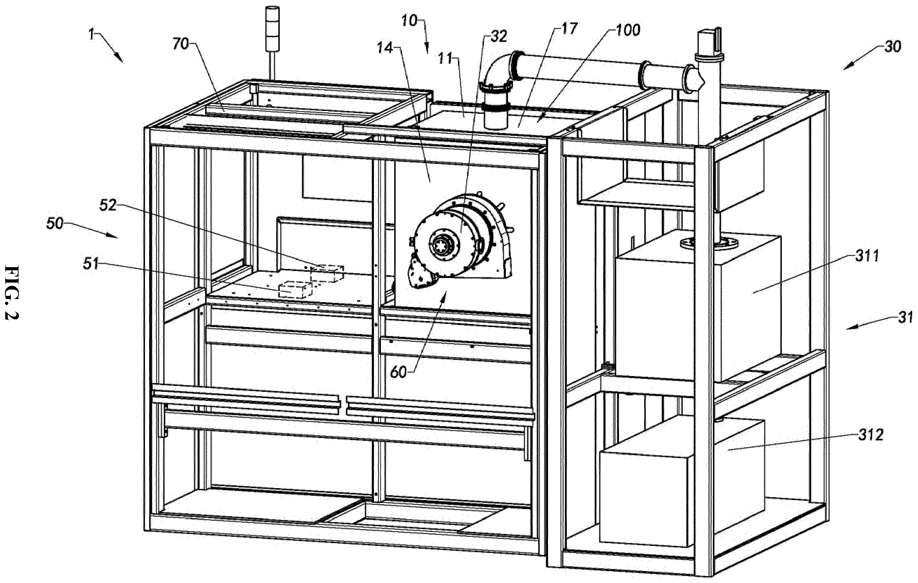

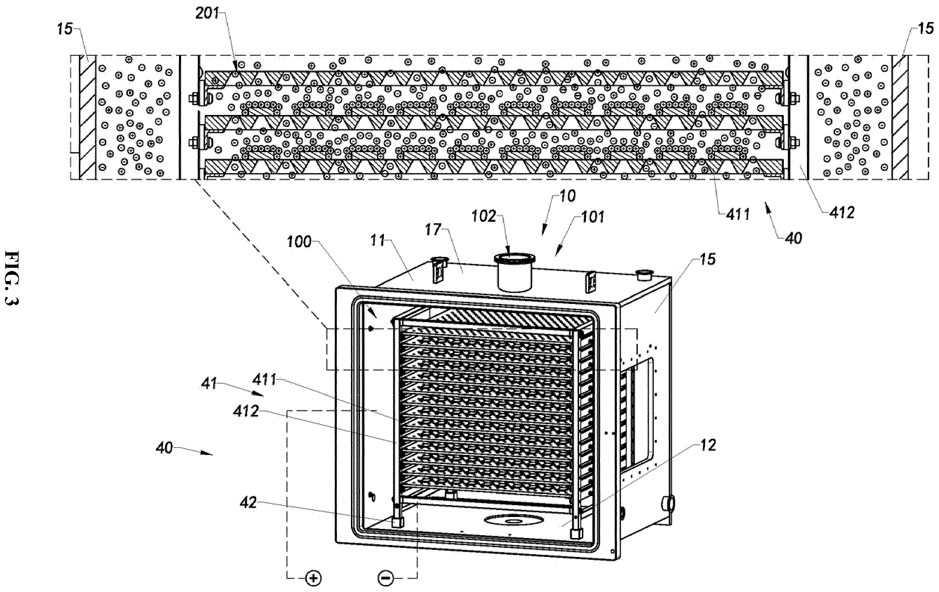

Referring to FIG. 1 to FIG. 3, a coating equipment 1 according to an embodiment of the present disclosure is illustrated. The coating equipment 1 can be applied to industrial production, so that a plurality of the workpieces can be coated in batches, and a higher product yield can be achieved.

The coating equipment includes a reaction chamber body 10, a gas supply part 20, a pumping device 30, and a support device 40.

The reaction chamber body 10 is provided with a reaction chamber 100, wherein the reaction chamber 100 is kept sealed relatively, so that the reaction chamber 100 can be kept at a desired vacuum degree.

The support device 40 is configured in the reaction chamber 100 and can be used to support a plurality of the workpieces. The support device 40 is adapted to hold the plurality of workpieces at positions with different heights in reaction chamber 100, and the support device 40 can be used as an electrode of a discharge device 50 of the coating equipment 1.

That is to say, the support device 40 can be used to support a workpiece, can be electrically coupled with the discharge device 50 to discharge in the reaction chamber 100. Therefore, utilization efficiency of the space in the reaction chamber body 10 can be improved, and the gas can get out of the reaction chamber body 10, so as to facilitate the uniform distribution of the gas in the workpiece.

Specifically, in this embodiment, the support device 40 includes a multi-layered support 41. The multi-layered support 41 includes a plurality of support parts 411 which are spaced apart from each other and held in the reaction chamber 100 in layers. The plurality of workpieces are supported on one or more layers of the multi-layered support 41.

The multi-layered support 41 has at least one gas outlet 201, wherein a plurality of gas outlets 201 are configured to pass through the support parts 411 in the height direction. Gas can flow through a gas outlet 201 to an opposite side of a support part 411, which facilitates uniform distribution of the gas supplied by the gas supply part 20 at the position of the support device 40.

The spaces defined by adjacent support parts 411 can communicate through the gas outlet 201, which is conductive to the uniformity of the gas environment on each layer of the support parts 411 where a workpiece is located. Therefore, it is conductive to the uniformity of the coating of the workpiece supported on the support part 411 at each layer.

More specifically, in this embodiment, the multi-layered support 41 includes a plurality of support parts 411 and at least two connecting parts 412, wherein the support parts 411 are supported by the connecting parts 412 so as to be held in the reaction chamber 100. In this embodiment, the connecting part 412 can be implemented as an upright post which may be hollow or solid.

A gas outlet 201 can also be configured in the connecting part 412, so that gas can pass through the connecting part 412, which is conductive to the diffusion of gas in the reaction chamber 100.

It is worth noting that, the support device 40 can not only be used to support a workpiece for gas diffusing, but also be used as an electrode for discharging.

Specifically, the entire support 41 can be configured to serve as a cathode and be electrically coupled with a pulse power supply 52 of a discharge device 50 of the coating equipment 1. That is, the entire support 41 may be supported by a conductive material, by way of example but not limitation, a metal. It can be understood that, the support 41 can be configured to serve as an electrode 53 of the discharge device 50, and the electrode 53 can also be configured on the support 41. That is to say, in some embodiments of the present disclosure, the electrode 53 and the support 41 may be independent of each other, for example, the electrode 53 is configured below or above or on the side of the support part 411 of the support 41, which should not limit the protection scope.

The support 41 is configured in the reaction chamber body 10 and held in the reaction chamber 100. In this embodiment, the support 41 is supported by the reaction chamber body 10, and when the support 41 is applied with a high voltage from a pulse power supply 52 to serve as a cathode, the reaction chamber body 10 can serve as an anode and be grounded.

The support device 40 of the coating equipment 1 further includes an insulating part 42, wherein the insulating part 42 can be configured at the bottom end of the connecting part 412 to insulate the multi-layered support 41 from the reaction chamber body 10. The manufacturing material of the insulating part 42 can be, but not limited to, tetrafluoroethylene.

It is worth noting that, the support part 411 and the inner wall of the reaction chamber body 10 need to be kept at a preset distance to avoid affecting the coating effect. Therefore, the height of the insulating part 42 and the height of the connecting part 412 need to be designed in advance.

It is worth noting that, the support part 411 is adapted to support a workpiece, and positive ions in plasma are accelerated from top to bottom and move toward the workpiece under the pulsed electric field to deposit on the surface of the workpiece. In this embodiment, the workpiece is supported on the support part 411 in a "lying" manner.

Further, the gas supply part 20 is used for supplying gas toward the reaction chamber 100 of the reaction chamber body 10.

The gas can be a reactant gas, and different reactant gases can be selected based on the requirements of the film layer. For example, when the film layer is a DLC film layer, the reactant gas may be CₓH_{y}, wherein x is an integer selected from 1 to 10, and y is an integer selected from 1 to 20. The reactant gas may be a single gas or a mixed gas. Optionally, the reaction gas can be methane, ethane, propane, butane, ethylene, acetylene, propylene or propyne in a gaseous state under normal pressure, or may be vapor formed by reducing pressure or heating evaporation. That is to say, the raw material that is liquid at normal temperature can also be supplied to the reaction chamber 100 in a gaseous state through the gas supply part 20.

The gas can be plasma source gas which includes, but not limited to, inert gas, nitrogen gas, and fluorocarbon gas. Wherein the inert gas includes, but not limited to, helium or argon. Fluorocarbon gas includes, but not limited to, carbon tetrafluoride. The plasma source gas may be a single gas, or a mixture of two or more gases.

The gas can be an auxiliary gas which can be combined with the reactant gas to form a film layer, so as to give the film layer some expected properties, such as strength, flexibility and the like. The auxiliary gas can be a non-hydrocarbon gas, such as nitrogen, hydrogen, fluorocarbon and the like. The auxiliary gas and the reactant gas may be supplied to the reaction chamber body 10 at a same time, or may be introduced in a sequential order according to requirements. When introducing the auxiliary gas, the ratio of each element in the film layer can be adjusted, such as the ratio of carbon-hydrogen bonds, carbon-nitrogen bonds and nitrogen-hydrogen bonds. Therefore, the properties of the film layer can be changed.

The pumping device 30 is connected with the reaction chamber body 10 in a manner of communicating with the reaction chamber 100. The pumping device 30 can be used to control the pressure in the reaction chamber 100. The pressure in the reaction chamber 100 affects the efficiency and final result of the entire coating process. During coating process, with the introduction of the gas raw material and the generation of plasma, the pressure in the entire reaction chamber 100 changes continuously in one stage. By adjusting the pumping power of the pumping device 30 and the gas supplying power of the gas supply part 20, the pressure in the reaction chamber 100 can be kept in an expected stable state.

That is to say, the pressure in the reaction chamber 100 can be reduced by means of the pumping device 30 to pump the gas in the reaction chamber 100, and the pressure in the reaction chamber 100 can be increased by means of the gas supply part 20 to supply gas in some processes. For example, when the coating process is finished, air or other gases can be supplied by the gas supply part 20, so that the pressure inside the reaction chamber 100 is the same as the pressure outside the reaction chamber body 10, the workpiece in the reaction chamber 100 can be taken out. According to at least one embodiment of the present disclosure, the flow rate of the reactant gas supplied in the gas supply range of the gas supply part 20 ranges from 10 sccm to 200 sccm. According to at least one embodiment of the present disclosure, the flow rate of the ion source gas of the gas supply part 20 ranges from 50 sccm to 500 sccm.

The support device 40 is configured in the reaction chamber 100 of the reaction chamber body 10. The support device 40 can be configured to support the workpiece to keep the workpiece held in the reaction chamber 100 of the reaction chamber body 10. A plurality of workpieces may be supported on the support device 40.

Further, the coating equipment 1 includes at least one discharge device 50, wherein the discharge device 50 can be configured to provide a radio frequency electric field and/or a pulsed electric field. Under the radio frequency electric field, the plasma gas source can be ionized to generate plasma. Under the pulsed electric field, the plasma can move toward the workpiece and deposit on the surface of the workpiece.

The discharge device 50 can be configured to provide alternating radio frequency electric fields and pulsed electric fields, or both radio frequency electric fields and pulsed electric fields at a same time.

Specifically, the discharge device 50 includes a radio frequency power supply 51, a pulse power supply 52 and at least one electrode 53, wherein the radio frequency power supply 51 can be used to generate a radio frequency electric field after being turned on, and can be configured outside the reaction chamber body 10 and electrically coupled with an electrode 53. The electrode 53 is configured in the reaction chamber 100. It can be understood that, the radio frequency power supply 51 can also be used to generate the alternating magnetic field without an electrode 53 to ionize the plasma gas source.

The pulse power supply 52 is configured outside the reaction chamber body 10, and the pulse power supply 52 is electrically coupled with an electrode 53, and the electrode 53 is configured in the reaction chamber 100. The electrode 53 serving as a cathode of the pulse power supply 52 is configured on one side of the workpiece to accelerate positive ions in plasma to move toward the workpiece. The electrode 53 is configured on the front side or the back side of the workpiece. The electrode 53 serving as an anode of the pulse power supply 52 is also configured in the reaction chamber body 10. The two electrodes 53 serving as the anode and the cathode of the pulse power supply 52 can be configured opposite to each other, for example, the two electrodes 53 are respectively configured on the front side and the back side of the workpiece, or the two electrodes 53 are respectively configured on two opposite sides of the workpiece.

The workpiece supported on the support device 40 can be coated under the radio frequency electric field and/or the pulsed electric field, and the radio frequency electric field and the pulsed electric field working together are explicated below.

Specifically, the radio frequency power supply 51 discharges the gas provided by the gas supply part 20 so that the entire reaction chamber 100 is in a plasma environment, and the reactant gas is in a high-energy state. The pulse power supply 52 generates a strong electric field during the discharge process, and the strong electric field is near the workpiece, so that the active ions in the plasma environment can be accelerated and deposited on the surface of the substrate under the strong electric field.

When the film layer is a DLC film layer, a reactant gas is deposited on the surface of the workpiece under a strong electric field to form an amorphous carbon network structure. When the pulse power supply 52 is not used to discharge, the film layer deposited on the workpiece is used for free relaxation of the amorphous carbon network structure. Under the action of thermodynamics, the carbon structure transforms to a stable phase, a curved graphene lamellar structure, and is embedded in the amorphous carbon network to form a transparent graphene-like structure.

More specifically, in this embodiment, the support device 40 includes a multi-layered support 41, wherein the multi-layered support 41 includes a plurality of support parts 411, the support parts 411 are spaced apart from each other and held in a stacked layers in the reaction chamber 100. The workpiece is supported on one or more layers of the multi-layered support 41.

The workpiece is held to connect with the electrode 53 serving as a cathode of the pulse power supply 52. After a plasma is generated by ionization under the pulsed electric field, positive ions in the plasma move towards the workpiece under the pulsed electric field to deposit on the surface of the workpiece. The plasma includes a conductive gaseous medium consisting of both electrons and positive ions.

It is worth mentioning that, since the electrode 53 serving as the cathode is configured around the workpiece, positive ions in the plasma can be accelerated and can deposit on the surface of the workpiece. On one hand, the coating speed of the workpiece can be increased, and on the other hand, positive ions may bombard the surface of the workpiece, which is conductive to a good strength of the film on the surface of the workpiece.

More specifically, in this embodiment, the multi-layered support 41 includes a plurality of the support parts 411 and at least two connecting parts 412, wherein the support parts 411 are supported by the connecting parts 412 so as to be held in the reaction chamber 100. In this embodiment, a connecting part 412 can be implemented as an upright post, wherein the upright post may be hollow or solid.

The entire support 41 can be used as a cathode and is electrically coupled with the pulse power supply 52. That is, the entire support 41 may be supported by a conductive material, by way of example but not limitation, a metal. It can be understood that, the support 41 can be configured to serve as an electrode 53, or an electrode 53 can also be configured on the support 41. That is to say, in some embodiments of the present disclosure, the electrode 53 and the support 41 may be independent of each other, for example, the electrode 53 is held below or above or on the side of the support part 411 of the support 41, which should not limit the protection scope.

The support 41 is configured in the reaction chamber body 10 and held in the reaction chamber 100. In this embodiment, the support 41 is supported by the reaction chamber body 10, and when the support 41 is applied with a high voltage from a pulse power supply 52 to serve as a cathode, the reaction chamber body 10 can serve as an anode and be grounded.

The support device 40 of the coating equipment 1 further includes an insulating part 42 which can be configured at the bottom end of the connecting part 412 to insulate the multi-layered support 41 from the reaction chamber body 10. The manufacturing material of the insulating part 42 can be, but not limited to, tetrafluoroethylene.

It is worth noting that, the support part 411 and the inner wall of the reaction chamber body 10 need to be kept at a preset distance to avoid affecting the coating effect. Therefore, the height of the insulating part 42 and the height of the connecting part 412 need to be designed in advance.

It is worth noting that, the support part 411 is adapted to support a workpiece, and positive ions in plasma are accelerated from top to bottom and move toward the workpiece under the pulsed electric field to deposit on the surface of the workpiece. In this embodiment, the workpiece is supported on the support part 411 in a "lying" manner.

The surface of the workpiece may be the surface to be coated made of glass, plastic, inorganic materials, and organic materials, which should not limit the protection scope. The workpiece may be electronic products, electrical components, semi-finished electronic assembly products, PCB boards, metal plates, polytetrafluoroethylene plates or electronic components. Moreover, the workpiece after being coated can be used in water environment, mold environment, acid and alkaline solvent environment, acid and alkaline salt spray environment, acidic atmospheric environment, organic solvent immersion environment, cosmetic environment, sweat environment, a cold and heat cycle impact environment or a humid and heat alternating environment.

The workpiece maybe an electronic device, such as a mobile phone, a tablet computer, an electronic reader, a wearable device, a display and the like, which should not limit the protection scope. After a layer of coating is formed on the surface of the workpiece, another layer of the same or a different coating may be formed by the coating equipment 1. That is, double-layered or multi-layered coating can be formed by the coating equipment 1. By changing the relevant parameters, such as the type of gas supplied by the gas supply part 20, the vacuum degree and voltage in the reaction chamber 100, different film layers for the same workpiece can be prepared by the same coating equipment 1.

The reaction chamber body 10 may be made of a conductive material which may be but not limited to a metal, such as a stainless steel material. The entire reaction chamber body 10 may be made of conductive material, or the part of the reaction chamber body 10 that needs to be used as an anode is made of a conductive material, and other parts may be made of a non-conductive material. The reaction chamber body 10 is made of stainless steel, and optionally, the roughness of the inner surface of the reaction chamber body 10 is less than 0.10 microns.

Further, the support part 411 of the multi-layered support 41 may be all made of conductive material, and the connecting part 412 may be also made of conductive material. Each support part 411 is configured to be electrically coupled with each other through the connecting part 412, and the conduction between the multi-layered support 41 and the pulse power supply 52 can be realized only with one conduction position. The support parts 411 of the multi-layered support 41 may all be made of conductive materials, the connecting part 412 may be made of an insulating material, and each support part 411 is insulated from each other. The conduction between the multi-layered support 41 and the pulse power supply 52 requires multiple conduction positions. The multi-layered support 41 may also be implemented by combining the above two methods, for example, at least two layers of the multi-layered support 41 are configured to be electrically coupled with each other, and at least one layer is configured to be independently electrically coupled with the pulse power supply 52.

In this embodiment, the entire multi-layered support 41 can be conductive and can act as a cathode. In other embodiments of the present disclosure, one layer or multiple layers of the entire multi-layered support 41 can be used as the cathode coupled with the pulse power supply 52.

Further, when the radio frequency power supply 51 is used to discharge without electrode, a radio frequency electric field can be distributed in the reaction chamber 100. For example, the radio frequency electric field is distributed above the workpiece. After the gas supplied by the gas supply part 20 being ionized above the workpiece, it can move from top to bottom toward the workpiece under the action of the support part 411 serving as a cathode to deposit on the surface of the workpiece.

The radio frequency electric field can also be distributed around the workpiece. After the gas supplied by the gas supply part 20 being ionized around the workpiece, it can move towards the workpiece under the action of the support member 411 serving as a cathode to deposit on the surface of the workpiece.

The radio frequency power supply 51 can also be used to discharge with an electrode 53, and the electrode 53 coupled with the radio frequency power supply 51 can be configured above the workpiece, or can be configured below the workpiece. At least a part of the gas supplied by the gas supply part 20 is ionized near the electrode 53 electrically coupled with the radio frequency power supply 51 to generate the plasma, and positive ions in the plasma can move toward the workpiece under the pulsed electric field.

It is worth noting that, the gas supply part 20 can be configured in accordance with the radio frequency electric field, so that the gas can be uniformly ionized under the radio frequency electric field.

The gas supply part 20 has a plurality of gas outlets, and a gas outlet 201 configured on the support device 40 can be used as the gas outlet of the gas supply part 20. Of course, it can be understood that the gas outlet 201 of the gas supply part 20 can be configured independently of the support device 40.

For example, when the radio frequency power supply 51 is used to discharge above the workpiece, the gas outlet 201 of the gas supply part 20 is configured above the workpiece, so that the gas from the feeding device can be ionized under the radio frequency electric field above the workpiece after leaving the gas outlet 201, and can then moves toward the workpiece from top to bottom under the pulsed electric field. Preferably, the radio frequency electric field is distributed uniformly above the workpiece in each layer, and the gas outlet 201 is configured uniformly above the workpiece in each layer.

When the radio frequency power supply 51 is used to discharge around the workpiece, the gas supply part 20 can also be configured around the workpiece, so that the gas from the feeding device can be ionized under the radio frequency electric field around the workpiece after leaving the gas outlet 201, and can then moves toward the surrounding workpiece under the pulsed electric field. Preferably, the radio frequency electric field is distributed uniformly around the workpiece, and the gas outlet 201 is configured uniformly around the workpiece in each layer.

Further, the coating equipment 1 includes a feeding device 60, wherein the feeding device 60 is connected with the reaction chamber body 10 in a manner of being electrically coupled with the reaction chamber 100. The feeding device 60 is configured outside the reaction chamber body 10 for feeding material. The raw material in gas state or liquid state can enter the feeding device 60, and then be transmitted to the gas supply part 20 configured in the reaction chamber 100 of the reaction chamber body 10 by the feeding device 60, and the gas is delivered to the reaction chamber 100 at a preset position by the gas supply part 20. By controlling the feeding device 60, the flow rate of the gas can be controlled, so that the rate of the reaction can be controlled.

The reaction chamber body 10 includes a top plate 11, a bottom plate 12, a front plate 13, a rear plate 14 and two side plates 15. The top plate 11 and the bottom plate 12 are configured opposite to each other, the front plate 13 and the rear plate 14 are configured opposite to each other, and the two side plates 15 are configured opposite to each other. And each side plate 15 is configured to connect with the top plate 11 and the bottom plate 12 respectively, and each side plate 15 is configured to connect with the front plate 13 and the rear plate 14 respectively.

The top plate 11, the bottom plate 12, the front plate 13, the rear plate 14 and the side plate 15 are tightly connected, so that a relatively sealed space can be formed in the reaction chamber 100, and the vacuum degree in the reaction chamber 100 can be precisely controlled.

The reaction chamber body 10 further includes a control door 16 and a reaction chamber device 17, wherein the control door 16 is configured to connect with the reaction chamber device 17 in a manner of being opened or closed. When the control door 16 is opened, the reaction chamber 100 is exposed, and when the control door 16 is closed, the reaction chamber 100 is closed.

The control door 16 may be a front plate 13. That is, the reaction chamber body 10 can be opened from the front side. The control door 16 may also be the top plate 11. That is, the reaction chamber body 10 may also be opened from the top side. It should be understood by those skilled in the art that, the form of opening the reaction chamber body 10 here is only for examplification, and the opening method of the reaction chamber body 10 of the coating equipment 1 of the present disclosure are not limited to this.

In this embodiment, the reaction chamber body 10 is configured in a rectangular structure, and when the operator faces the front plate 13 of the reaction chamber body 10 when operating or observing the internal conditions of the reaction chamber body 10. In other embodiments of the present disclosure, the reaction chamber body 10 may be a cylindrical structure or a circular structure. It can be understood by those skilled in the art that, this is just for an example, and the shape of the reaction chamber body 10 is not limited to above examples.

Optionally, the reaction chamber body 10 includes an observation window, wherein the observation window is configured on the front plate 13 to facilitate the operator to observe.

In this embodiment, the reaction chamber body 10 has a feeding inlet 101, wherein the feeding inlet 101 may be configured on the rear plate 14 of the reaction chamber body 10. The feeding device 60 may be communicably connected with the feeding inlet 101. The gas supply part 20 may be communicably connected with the feeding inlet 101.

Further, the pumping device 30 includes a primary pumping unit 31 and an advanced pumping unit 32, wherein the primary pumping unit 31 and the advanced gas pumping 32 are respectively communicably connected with the reaction chamber body 10.

The primary pumping unit 31 is used for pumping the reaction chamber body 10 primarily, the advanced pumping unit 32 is used for pumping the reaction chamber body 10 secondarily. For example, the primary pumping unit 31 can be used to pump roughly the gas in the reaction chamber body 10. For example, reducing the air pressure by one or more orders of magnitude. The advanced pumping unit 32 can be used to pump the gas in the reaction chamber body 10 precisely, for example, reducing the air pressure to a more precise range within the same order of magnitude.

The reaction chamber body 10 has at least one pumping port 102, and the pumping device 30 is configured to pump the gas from the reaction chamber body 10 through the pumping port 102. It can be understood that, the primary pumping unit 31 and the advanced pumping unit 32 of the pumping device 30 may share one pumping port 102. The primary pumping unit 31 and the advanced pumping unit 32 of the pumping device 30 may be respectively communicated with one pumping port 102.

In this embodiment, a pumping port 102 is configured on the top plate 11 of the reaction chamber body 10, and the other pumping port 102 is configured on the rear plate 14 of the reaction chamber body 10. The pumping port 102 configured on the top plate 11 of the reaction chamber body 10 is communicated with the primary pumping unit 31. The pumping port 102 configured on the rear plate 14 of the reaction chamber body 10 is communicated with the advanced pumping unit 32.

The coating equipment 1 further includes a mounting frame 70, wherein the reaction chamber body 10 is supported by the mounting frame 70 to be held in a position with a certain height. The primary pumping unit 31 of the pumping device 30 is supported by the mounting frame 70 and held at one side of the reaction chamber body 10. The advanced pumping unit 32 of the pumping device 30 is supported by the mounting frame 70 and held on the back side of the reaction chamber body 10.

In this embodiment, the primary pumping unit 31 includes a Roots pump 311 and a dry pump 312, wherein the Roots pump 311 and the dry pump 312 are respectively communicably connected with the reaction chamber body 10. The Roots pump 311 and the dry pump 312 can be used in combination. The dry pump 312 is arranged above the Roots pump 311 or the Roots pump 311 is arranged above the dry pump 312, as such, the dry pump 312 and the Roots pump 311 is overlapped so as to reduce the area size of the entire coating equipment 1.

The size of the multi-layered support 41 of the support device 40 is smaller than the size of the reaction chamber 100 of the reaction chamber body 10, so that the multi-layered support 41 can be accommodated in the reaction chamber 100.

The reaction chamber body 10 has an opening, wherein the opening is communicated with the reaction chamber 100, when the control door 16 is opened, the multi-layered support 41 can be configured in the reaction chamber 100 through the opening. When the coating is completed, the control door 16 can be opened, and the multi-layered support 41 can be directly taken out of the reaction chamber 100. The workpiece supported on the multi-layered support 41 can also be taken out together with the multi-layered support 41.

The multi-layered support 41 can be used to hold a plurality of workpiece, and the reaction chamber body 10 can be designed with a preset size to accommodate the multi-layered support 41 and a plurality of workpiece, so that the coating of a plurality of workpiece can be completed at one time.

Further, in this embodiment, after the vacuum degree in the reaction chamber body 10 is controlled within a certain range by the pumping device 30, the feeding device 60 feeds the reaction chamber body 10, and the discharge device 50 can be energized to generate an electric field in the reaction chamber 100 to ionize at least a part of the gas.

For example, the feeding device 60 can provide Ar/N₂/H₂/CH₄ into the reaction chamber body 10 at a flow rate of 50-500 sccm, and provide C₂H₂/O₂ into the reaction chamber body 10 at a flow rate of 10-200 sccm, and the vacuum degree in the reaction chamber body 10 can be controlled by the pumping device 30 to be less than 2 × 10⁻³Pa before coating. When the coating starts, the coating vacuum degree in the reaction chamber body 10 can be maintained at 0.1-20 Pa.

During the coating process, the voltage generated by the discharge device 50 can be maintained in a range of -300V to -3500V, the duty ratio ranges from 5% to 100%, and the frequency ranges from 20KHz to 360KHz. The coating time is approximately between 0.1 hour and 5 hours. Finally, the thickness of the obtained coating does not exceed 50nm. Of course, as the coating time increases, the thickness of the coating can become thicker.

It is worth mentioning that, a transparent coating can be obtained by the coating equipment 1.

In more detail, in some embodiments of the present disclosure, by the coating equipment 1, an inorganic film layer can be obtained, such as a diamond-like carbon film layer. For example, the flow rate of CₓH_{y} ranges from 50 sccm to 1000 sccm, the flow rate of inert gas ranges from 10 sccm to 200 sccm, the gas flow rate of H₂ ranges from 0 sccm to 100 sccm, the pressure of vacuum reaction chamber 100 ranges from 0.01 Pa to 100 Pa, the radio frequency power ranges from 10W to 800W, and the bias power supply voltage ranges from -100V to -5000V, the duty ratio ranges from 10% to 80%, and the coating time ranges from 5min to 300min.

The ratio of the flow rate between different gases determines the atomic ratio of the obtained DLC film layer, which affects the quality of the film layer. The level of the power supply of the discharge device 50 determines the temperature increase, ionization rate, deposition rate and other related parameters of the ionization process. If the coating time is too short, the film layer is thin and the hardness may be poor. If the coating time is too long, the film layer is thick, but which may affect the transparency.

In other embodiments of the present disclosure, an organic film layer can be obtained by the coating equipment 1. For example, perform the following step I or step II at least once to prepare an organosilicon nanocoating with a modulated structure on the surface of the substrate.

step I: introduce monomer A vapor into the reaction chamber body 10 until the vacuum degree reaches 30 mTorr to 300 mTorr, start a plasma discharge, conduct a chemical vapor deposition and stop introducing monomer A vapor; introduce monomer B vapor, keep plasma discharge, conduct a chemical vapor deposition, and stop introducing monomer B vapor.

step II: introduce the monomer B vapor into the reaction chamber body 10 until the vacuum degree reaches 30 mTorr to 300 mTorr, start a plasma discharge, conduct a chemical vapor deposition, and stop introducing the monomer B vapor; introduce the monomer A vapor, keep plasma discharge, conduct a chemical vapor deposition, and stop introducing monomer A vapor.

In the step (1), the reaction chamber body 10 may be a rotary body-shaped chamber or a cube-shaped chamber, and its volume ranges from 50L to 1000 L. The temperature of the reaction chamber body 10 is controlled at 30°C ~ 60°C, and the flow rate of inert gas ranges from 5 sccm to 300 sccm. In the step (2): a plasma discharge is started, chemical vapor deposition is performed, and the plasma discharge process in the deposition process includes a low-power continuous discharge, a pulse discharge or a periodic alternating discharge. In the deposition process, the plasma discharge process is a low-power continuous discharge, which specifically includes at least one of the following deposition processes: a pretreatment stage and a coating stage. The plasma discharge power in the pretreatment stage ranges from 150W to 600W, and the continuous discharge time ranges from 60s to 450s. Then, start the coating stage, adjust the plasma discharge power to the range from 10W to 150W, and continuously discharge from 600s to 3600s. In the deposition process, the plasma discharge process is a pulse discharge, which specifically includes at least one of the following deposition processes: a pretreatment stage and a coating stage. The plasma discharge power in the pretreatment stage ranges from 150W to 7600W, and the continuous discharge time ranges from 60s to 450s. Then start the coating stage. The coating stage is a pulse discharge. The power ranges from 10W to 300W, the time ranges from 600s to 3600s, the frequency of the pulse discharge ranges from 1Hz to 1000Hz, and the duty ratio of the pulse ranges from 5% to 90%.

In the deposition process, the plasma discharge process is a periodic alternating discharge, which specifically includes at least one of the following deposition processes: a pretreatment stage and a coating stage. The plasma discharge power in the pretreatment stage ranges from 150W to 600W, and the continuous discharge time ranges from 60s to 450s. Then start the coating stage. In the coating stage, the plasma is a periodic alternating discharge output, the power ranges from 10W to 300W, the time ranges from 600s to 3600s, the alternating frequency ranges from 1Hz to 1000Hz, and the plasma periodic alternating discharge output waveform is sawtooth waveform, sine waveform, square waveform, full-wave rectified waveform or half-wave rectified waveform.

Further, the power supply of the discharge device 50 may be the pulse power supply 52 and/or the radio frequency power supply 51. The pulse power supply 52 can be used alone, and the radio frequency power supply 51 can also be used alone. Alternatively, the pulse power supply 52 is used in conjunction with other devices, such as microwave or radio frequency, or the radio frequency power supply 51 is used in conjunction with other devices, such as microwave or pulse.

In this embodiment, the radio frequency power supply 51 and the pulse power supply 52 in the discharge device 50 can be used together. For example, the radio frequency power supply 51 can be used as the power supply of the inductively coupled ion source, and then an alternating magnetic field can be generated through the inductive coupling effect of the coil, therefore, gas power can be generated. The power of the radio frequency power supply 51 may range from 12MHz to 14MHz, such as 13.56MHz.

The pulse power supply 52 can be applied on the electrode 53 serving as a cathode to ionize the gas through the glow discharge effect, which in turn generate a directional traction and acceleration effect on the positive ions generated by the ionization, such that a bombardment is generated in the deposition process to obtain a dense and high hardness film layer.

The simultaneous application of the radio frequency power supply 51 and the pulse power supply 52 makes it possible to obtain a plasma with a high ionization rate during the reaction process, and the energy is increased when the plasma reaches the surface of the substrate, which is beneficial to obtain a dense and transparent film layer.

For example, according to at least one embodiment of the present disclosure, a DLC film layer can be obtained by the coating equipment 1. Firstly, clean and pretreat the surface of the workpiece. Specifically, clean the surface of the workpiece made of glass, metal, plastic and other materials with alcohol or acetone and other solvents, and then wipe it with a clean cloth or dry it after soaking it in ultrasonic; place the workpiece in a vacuum reaction chamber, and vacuum the vacuum reaction chamber to get the pressure below 10 Pa, preferably below 0.1Pa, introduce high-purity helium or argon gas as the plasma gas source, and turn on the high-voltage pulse power supply 52. The glow discharge generates plasma, the sample surface is etched and activated, and then a DLC film is deposited. Doped diamond-like carbon films can be prepared by plasma chemical vapor deposition by a radio frequency power supply and a high voltage pulse power supply: introduce the DLC film reaction gas source, the reaction raw material doped with element, and hydrogen, turn on a radio frequency power supply 51 and a high voltage pulse power supply 52 to conduct plasma chemical vapor deposition. After a period of time, the film deposition process is completed. Introduce air or inert gas to make the pressure in the vacuum chamber to be a normal pressure, and take out the sample.

It is worth noting that, the magnitude of the negative bias voltage of the pulse power supply 52 can be related to the ionization of the gas and the migration ability of the gas when it reaches the surface of the product. High voltage means higher energy, high hardness coatings can be obtained. However, an ion with too high energy may have a strong bombardment effect on the workpiece, and bombardment pits may be formed on the surface of the workpiece on the microscopic scale. At the same time, the high-energy bombardment may accelerate temperature rising, which may lead to the temperature of the workpiece rising.

Further, in this embodiment, the pulse frequency of the pulse power supply 52 may range from 20KHz to 300KHz. By reducing the continuous accumulation of electric charge on the surface of the insulating workpiece, the large arc phenomenon is suppressed and the maximum thickness of the coating deposition is increased.

It is worth noting that, when using the coating equipment 1 to coat, by controlling various parameters, the entire coating process can be kept at a low temperature, such as 25°C to 100°C, or 40°C to 50°C.

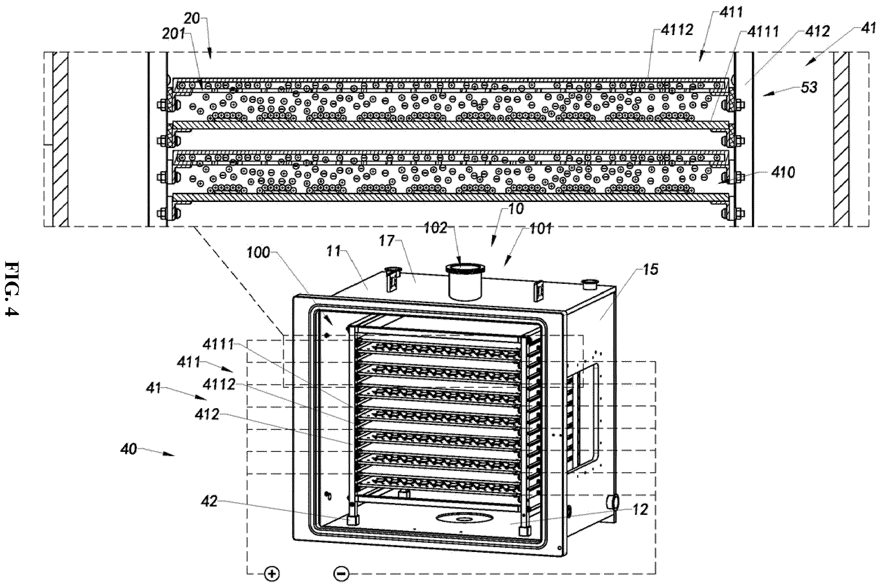

Referring to FIG. 4, and FIG. 1 to FIG. 3, another embodiment of the coating equipment 1 of the above embodiment of the present disclosure is illustrated.

The differences between this embodiment and the above embodiments mainly lies in the electrode arrangement and the support device 40. In the above embodiment, the support device 40 is independent of the reaction chamber body 10 and the multi-layered support 41 can be used as an electrode that is electrically coupled with the pulse power supply 52.

In this embodiment, the multi-layered support 41 can be used not only as an electrode, but also as at least a part of the gas supply part 20.

Specifically, in this embodiment, a part of the support part 411 is used as an electrode 53 that is electrically coupled with the pulse power supply 52, and a part of the support part 411 can be used as the gas supply part 20.

For example, there are six layers of the support parts 411 of the multi-layered support 41, which includes the first layer to the sixth layer respectively from top to bottom. The first layer, the third layer, and the fifth layer can be used to supply gas respectively, and the second layer, the fourth layer, and the sixth layer can be used to respectively electrically coupled with the pulse power supply 52 and be used as cathodes.

The support parts 411 on the first, third and fifth layers have at least one gas outlet 201 which is configured toward the support part 411 on the next layer. The support parts 411 on the second layer, the fourth layer and the sixth layer are used for holding the workpiece.

Preferably, the gas outlets 201 of the support parts 411 are multiple, and the gas outlets 201 are configured to be evenly distributed above the workpiece, so that the gas is supplied uniformly to the workpiece.

The support part 411 for supplying gas may be hollow, the gas from the feeding device 60 can be introduced into the support part 411 and diffuse towards the support part 411 on the lower layer via the gas outlet 201.

It is worth mentioning that, the support part 411 for supplying gas is configured to be conductive and electrically coupled with the radio frequency power supply 51, when the radio frequency power supply 51 is turned on, at least part of the gas in the support parts 411 on the first layer, the third layer and the fifth layer can be ionized under the radio frequency electric field to form plasma, and then, the plasma leaves the support 411 via the gas outlet 201 to move toward the workpiece under the pulsed electric field, and can be accelerated and deposited on the surface of the workpiece. Optionally, the area of the support part 411 serving as at least part of the gas supply part 20 ranges from 500mm × 500mm to 700mm × 700mm.

The support device 40 includes a plurality of reaction spaces 410, wherein the reaction spaces 410 are formed between adjacent support parts 411. Optionally, according to at least one embodiment of the present disclosure, the distance between the adjacent support parts 411 ranges from 10mm to 200mm. The diameter of the gas outlet 201 ranges from 3 mm to 5 mm.

For the workpiece in the same reaction space 410, for example, the workpiece on the second layer, above the workpiece, where the support part 411 on the first layer can provide positive ions uniformly, and the positive ions can uniformly move toward the workpiece on the second layer. The same situation applies to the workpiece on the fourth or sixth layer.

From another point of view, the radio frequency electric field and the pulse electric field are alternately arranged, so as to ensure the uniformity of the electric field of the workpiece in each layer.

Preferably, each support part 411 serving as at least a part of the gas supply part 20 is the same, and each support part 411 electrically coupled with the pulse power supply 52 is the same.

Optionally, the distance between the support part 411 serving as the gas supply part 20 and the support part 411 serving as the electrode of the pulse power supply 52 on the next layer is the same. That is, the size of each reaction space 410 may be the same. Optionally, each support part 411 is parallel to each other. Optionally, the reaction chamber body 10 is a symmetrical structure, such as a rectangular structure, or a cylindrical structure. The support device 40 is configured on the central axis of the reaction chamber body 10.

Further, the area of the support part 411 serving as the gas supply part 20 and the area of the support part 411 serving as the electrode of the pulse power supply 52 on the next layer may be the same.

It can be understood that, since adjacent support parts 411 are respectively coupled with the radio frequency power supply 51 and the pulse power supply 52, the adjacent support parts 411 are insulated from each other. For example, the support part 411 on the first layer, the third layer and the fifth layer are respectively configured on the connecting part 412 in an insulating manner. The first layer, the third layer and the fifth layer are respectively electrically coupled with the radio frequency power supply 51. The support parts 411 on the second layer, the fourth layer and the sixth layer are respectively configured to the connecting part 412 in an insulating manner. The support parts 411 on the second layer, the fourth layer and the sixth layer are respectively electrically coupled with the pulse power supply 52. Optionally, the first layer, the third layer, and the fifth layer may be respectively electrically coupled with the connecting part 412, so as to be electrically coupled with the radio frequency power supply 51. The second layer, the fourth layer and the sixth layer are respectively electrically coupled with the pulse power supply 52 and insulated from the connecting part 412.

It should be understood by those skilled in the art that, the above-mentioned connection manners between each layer of the support 41 and the pulse power supply 52 or the radio frequency power supply 51 are merely for illustration.

Further, it can be understood that the electrode 53 being electrically coupled with the pulse power supply 52 can be separately configured on the support 41, and configured under the support part 411 on which the workpiece is supported.

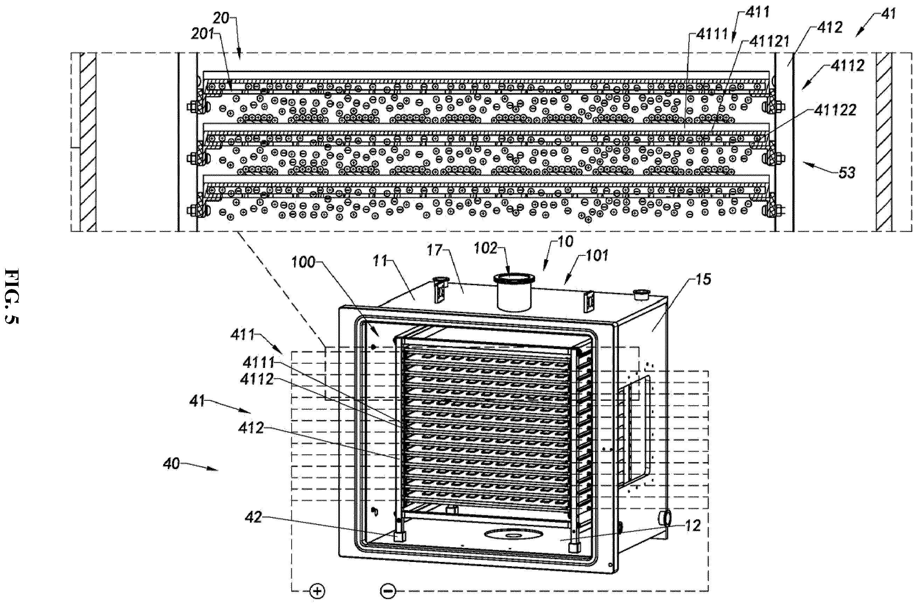

Referring to FIG. 5, and FIG. 1 to FIG. 3, another embodiment of the coating equipment 1 of the above embodiment of the present disclosure is illustrated. The difference between this embodiment and the above embodiment is mainly in the support device 40 and the discharge device 50.

In this embodiment, a part of the support 41 of the support device 40 can be used as the gas supply part 20.

Specifically, the support part 411 of the support 41 includes a first support portion 4111 and a second support portion 4112, wherein the first support portion 4111 is configured and supported on the second support portion 4112.

Each of the first support portion 4111 and the corresponding second support portion 4112 can be used as a layer, the first support portion 4111 can be electrically coupled with the pulse power supply 52 to serve as a cathode, and the second support portion 4112 can be used as the gas supply portion 20.

For example, when the support parts 411 of the support 41 is on at least two layers, for the workpiece supported on the second layer of the support part 411, the second support portion 4112 of the support part 411 on the first layer is above the workpiece, and the workpiece is supported by the first support portion 4111 of the support part 411 on the second layer.

When the second support portion 4112 of the support part 411 on the first layer is used to supply gas, and the gas is ionized into plasma under the radio frequency electric field, under the pulsed electric field generated by the first support portion 4111 of the support part 411 on the second layer, the plasma above the workpiece moves from top to bottom toward the workpiece supported on the support part 411 on the second layer, so as to accelerate deposition on the surface of the workpiece.

Further, the second support portion 4112 of the support part 411 on the first layer may be electrically coupled with the radio frequency power supply 51, so that the gas can be directly ionized under the radio frequency electric field near the second support portion 4112 of the support part 411 on the first layer.

It is worth noting that, since each support part 411 includes the first support portion 4111 and the second support portion 4112, most of the support part 411 of the support 41 can be used to hold the workpiece. In other words, the support part 411 on each layer of the support 41 can be used to hold the workpiece. In addition to the support part 411 on the first layer, the second support portion 4112 for gas supply may be configured above the workpiece on other layers, and the workpiece may be supported by the first support portion 4111 serving as a cathode below.

Further, the second support portion 4112 may be hollow and have a plurality of gas outlets 201, wherein the plurality of gas outlets 201 are evenly configured above the workpiece, so as to facilitate the uniform feeding gas for the workpiece.

The section of the gas outlet position of the second support portion 4112 in the longitudinal direction may be rectangular or trapezoidal.

The first support portion 4111 serving as an electrode 53 may be of a plate-like structure, and the second support portion 4112 serving as the gas supply part 20 may be of a plate-like structure or a net-like structure or a hollowed-out structure.

More specifically, the second support portion 4112 may include a support top plate 41121 and a support bottom plate 41122, and a space is configured between the support top plate 41121 and the support bottom plate 41122 of the second support portion 4112 for temporarily storing gas. The support top plate 41121 and the support bottom plate 41122 of the second support portion 4112 may be insulated from each other, the support top plate 41121 and the support bottom plate 41122 can be used as the discharge electrodes 53 of the radio frequency power supply 51.

The first support portion 4111 is configured on the support top plate 41121 of the second support portion 4112 in an insulating manner, and the first support portion 4111 is used as the discharge electrode 53 of the pulse power supply 52.

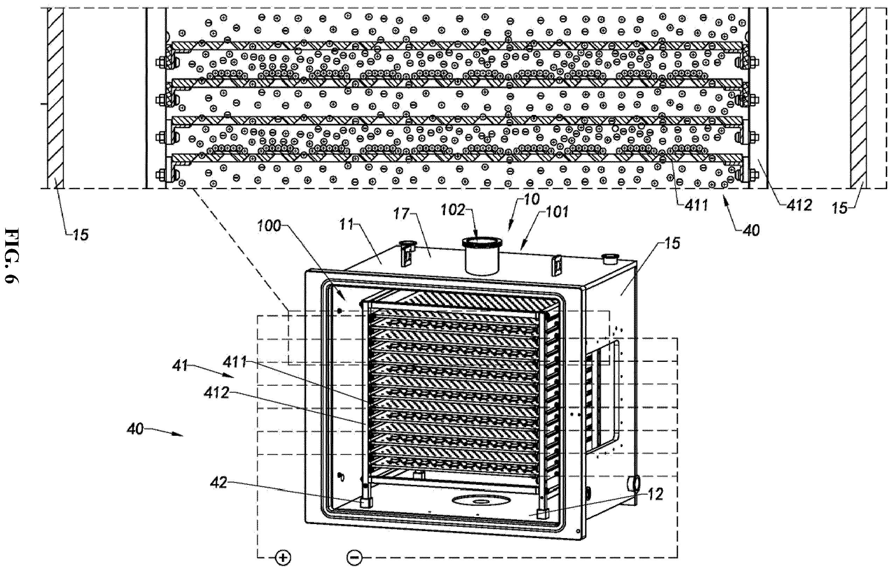

Referring to FIG. 6, and FIG. 1 to FIG. 3, another embodiment of the coating equipment 1 according to the above embodiment of the present disclosure is illustrated.

The difference between this embodiment and the above embodiment is mainly in the support device 40 and the discharge device 50.

The support part 411 of the support 41 are respectively electrically coupled with the pulse power supply 52, and adjacent support parts 411 are respectively used as the anode and the cathode of the pulse power supply 52. That is to say, the reaction chamber body 10 does not need to be used as the anode in this embodiment. That is to say, the reaction chamber body 10 does not need to be used as the anode in this embodiment.

For example, the support 41 has at least six layers, wherein the first layer, the third layer and the fifth layer are respectively used as the anode of the pulse power supply 52, and the second layer, the fourth layer and the sixth layer are respectively used as the cathode of the pulse power supply 52.

The workpiece is supported on the second layer, the fourth layer and the sixth layer, and positive ions in the plasma generated by ionization under the radio frequency electric field can move toward the workpiece.

It is worth noting that, the adjacent support parts 411 are insulated from each other, for example, the insulating part 42 may be configured between the support part 411 on the first layer and the support part 411 on the second layer, so that the adjacent support parts 411 cannot be electrically coupled with each other.

According to other embodiments of the present disclosure, when at least part of the support part 411 of the support 41 is electrically coupled with the pulse power supply 52 to serve as a cathode of the pulse power supply 52, at least a part of the support part 411 of the support 41 may be configured to be grounded, and the support part 411 serving as the cathode of the pulse power supply 52 and the support 411 grounded may be alternately configured.

According to other embodiments of the present disclosure, when at least a part of the support part 411 of the support 41 is electrically coupled with the pulse power supply 52 to serve as a cathode of the pulse power supply 52, at least a part of the support part 411 of the support 41 is electrically coupled with the radio frequency power supply 51 to serve as an anode of the radio frequency power supply 51, and the support part 411 serving as a cathode of the pulse power supply 52 and the support part 411 serving as an anode of the radio frequency power supply 51 may be alternately configured.

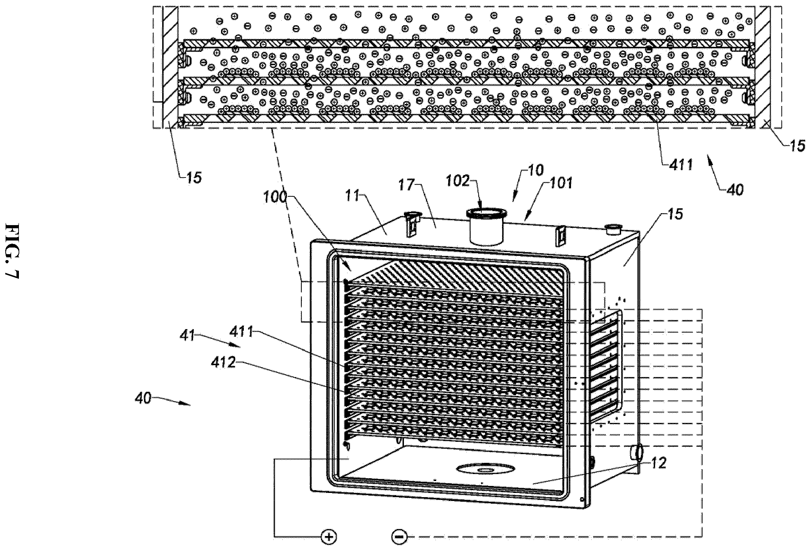

Referring to FIG. 7, and FIG. 1 to FIG. 3, another embodiment of the coating equipment 1 according to the above embodiment of the present disclosure is illustrated.

The difference between this embodiment and the above embodiment is mainly in the support part 411 of the support 41.

The support part 411 of the support 41 is configured to be supported on the inner wall of the reaction chamber body 10. The inner wall of the reaction chamber body 10 may be configured to be concave, and each support part 411 can be supported on the reaction chamber body 10.

The support part 411 can be used as the electrode 53 of the pulse power supply 52, and the entire support 41 can be used as the cathode of the pulse power supply 52. Alternatively, a part of the support part 411 may also be used as the cathode of the pulse power supply 52, and a part of the support part 411 may be used as the anode of the pulse unit. Alternatively, a part of the support part 411 may also be used as the electrode 53 of the radio frequency power supply 51. The gas supply part 20 may be configured on the support part 411.

It can be understood that, the above-mentioned configuration of the electrodes 53 is for illustration, and the configuration of the electrodes 53 of the coating equipment 1 of the present disclosure is not limited to these.

Further, the support part 411 is detachably connected with the reaction chamber body 10, when the workpiece needs to be held in or taken out from the reaction chamber body 10, the support part 411 can be separated from the reaction chamber body 10.

According to other embodiments of the present disclosure, the support device 40 is rotatably configured on the reaction chamber body 10. That is to say, the support device 40 and the reaction chamber body 10 can move relative each other, so as to facilitate the sufficient contact between the radio frequency electric field or the pulsed electric field and the gas or plasma.

It is worth noting that, in the above embodiment, the support part 411 is adapted to support the workpiece so that the workpiece lies in the reaction chamber 100, and the upper front surface or the downward back surface of the workpiece can be coated. Double-sided surface can be coated by the coating equipment 1.

In other embodiments of the present disclosure, the workpiece is held in the reaction chamber 100 in an upright post manner, and the support part 411 is configured in the reaction chamber 100 in an upright post manner.

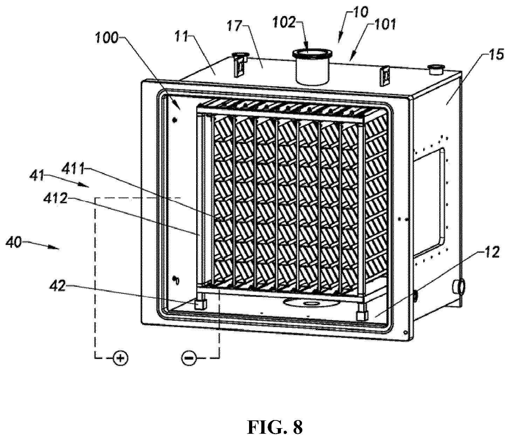

Referring to FIG. 8, the support 41 includes a plurality of the support parts 411 and at least one connecting part 412, wherein the plurality of the support parts 411 are configured in the reaction chamber 100 at a preset distance from each other, the connecting part 412 is connected with each support part 411 to keep the support part 411 in a preset position. The connecting part 412 may be multiple, such as two or more.

In this embodiment, the support part 411 is implemented as a rectangular plate, and the connecting parts 412 may be multiple such as four, which are respectively configured at four top corners of the support part 411.

The support 41 is configured in the reaction chamber 100 in a manner of being insulated from the reaction chamber body 10, wherein the entire support 41 can be used as the cathode of the pulse power supply 52.

It is worth noting that, a plurality of the gas outlets 201 are configured on the support part 411, wherein the raw material gas or the ionized plasma can pass through the support part 411 to diffuse throughout the support 41.

Those skilled in the art will appreciate that, the embodiments of the present disclosure shown in the foregoing description and the accompanying drawings are by way of example only and are not intended to limit the present disclosure. The advantages of the present disclosure have been completely and effectively realized. The functionality and structural principles of the present disclosure have been shown and illustrated in the embodiments, and embodiments of the disclosure may be varied or modified without departing from the principles described herein.

## Claims

1. A coating equipment for coating at least one workpiece, comprising:
a reaction chamber body provided with a reaction chamber;
a gas supply part configured to supply gas to the reaction chamber;
a pumping device configured to communicate with the reaction chamber and to pump the gas in the reaction chamber to control the vacuum degree; and
a pulse power supply adapted to provide the reaction chamber body with a pulsed electric field, wherein the reaction chamber is adapted to accommodate a plurality of workpiece, when the pulse power supply is turned on, the gas in the reaction chamber body is ionized under the pulsed electric field to generate plasma to deposit on the surface of a workpiece.

2. The coating equipment according to claim 1, further comprising: a radio frequency power supply adapted to provide the reaction chamber body with a radio frequency electric field, wherein when the radio frequency power supply is turned on, the plasma is deposited on the surface of the workpiece under the pulsed electric field and the radio frequency electric field.

3. The coating equipment according to claim 1 or claim 2, further comprising at least one electrode configured on one side of the workpiece as a cathode of the pulse power supply to accelerate the positive ions in the plasma to move towards the workpiece.

4. The coating equipment according to claim 3, wherein at least one electrode is configured on the other side of the workpiece as a cathode of the pulse power supply to form the pulsed electric field.

5. The coating equipment according to claim 3, wherein at least one electrode is configured in the reaction chamber body as an anode of the pulse power supply.

6. The coating equipment according to claim 3, further comprising a multi-layered support, comprising a plurality of support parts which are configured in the reaction chamber at a preset spacing, wherein a plurality of workpieces are respectively supported by the plurality of support parts, and the electrode serving as the cathode of the pulse power supply is configured on at least one support part.

7. The coating equipment according to claim 2, further comprising a multi-layered support comprising a plurality of support parts, wherein a plurality of workpieces are respectively supported by the plurality of support parts, and at least one support part serves as a cathode of the pulse power supply.

8. The coating equipment according to claim 7, wherein at least one support part serves as an electrode of the radio frequency power supply.

9. The coating equipment according to claim 6 or claim 7, wherein at least one support part serves as an anode of the pulse power supply.

10. The coating equipment according to claim 8, wherein the electrode of the radio frequency power supply is configured above a workpiece and the workpiece is supported by a support part serving as the cathode of the pulse power supply.

11. The coating equipment according to claim 9, wherein the support part serving as the anode of the pulse power supply is configured above a workpiece and the workpiece is supported by a support part serving as the cathode of the pulse power supply.

12. The coating equipment according to claim 9, wherein the support part serving as the cathode of the pulse power supply and the support part serving as the anode of the pulse power supply are alternately configured.

13. The coating equipment according to claim 7, wherein at least one layer of the multi-layered support serves as the gas supply part, and the support part serving as the gas supply part is configured above a workpiece.

14. The coating equipment according to claim 13, wherein the support part serving as the gas supply part comprises a top plate and a bottom plate, and a space is configured between the top plate and the bottom plate for temporarily storing gas, and at least one gas outlet is configured on the bottom plate, so that gas can get out of the upper position above the workpiece.

15. The coating equipment according to claim 14, wherein the support part serving as the gas supply part and the support part serving as the cathode of the pulse power supply are alternately configured.

16. The coating equipment according to claim 14, wherein the at least one gas outlet is evenly configured above the workpiece.

17. The coating equipment according to claim 14, wherein the support part serving as the gas supply part is electrically coupled with the radio frequency power supply.

18. The coating equipment according to any one of claim 13 to claim17, wherein the multi-layered support is configured in the reaction chamber body in a manner of being removable, the multi-layered support comprises at least two upright posts, and each of the support parts is configured on the at least two upright posts at a preset spacing.

19. The coating equipment according to claim 18, wherein the multi-layered support further comprises at least one insulating part, the insulating part is configured at the bottom end of an upright post to insulate the multi-layered support from the reaction chamber body.

20. The coating equipment according to any one of claim 13 to claim 17, wherein the multi-layered support is detachably supported on the reaction chamber body.

21. The coating equipment according to claim 20, wherein the support parts are configured in the reaction chamber body in parallel with each other.

22. The coating equipment according to claim 1 or claim 2, wherein the coating voltage of the pulse power supply ranges from -300 V to -3500 V, and the frequency of the pulse power supply ranges from 20 KHz to 360 KHz.

23. The coating equipment according to claim 1 or claim 2, wherein the duty ratio of the pulse power supply ranges from 5% to 100%.

24. The coating equipment according to claim 1 or claim 2, wherein the vacuum degree of the coating equipment before coating is controlled to be no more than 2 × 10⁻³Pa.

25. The coating equipment according to claim 1 or claim 2, wherein the vacuum degree of the coating equipment during a coating process ranges from 0.1Pa to 20Pa.

26. A coating equipment for coating at least one workpiece, comprising:
a reaction chamber body provided with a reaction chamber;
a gas supply part configured to supply gas to the reaction chamber;
a feeding device configured to communicate with the reaction chamber;
a pumping device configured to communicate with the reaction chamber and to pump the gas in the reaction chamber to control the vacuum degree; and
a pulse power supply adapted to provide the reaction chamber body with a pulsed electric field, wherein the reaction chamber is adapted to accommodate a plurality of workpieces, when the pulse power supply is turned on, the gas in the reaction chamber body is ionized under the pulsed electric field to generate plasma to deposit on the surface of a workpiece.

27. The coating equipment according to claim 26, further comprising a radio frequency power supply adapted to provide the reaction chamber body with a radio frequency electric field, wherein when the radio frequency power supply is turned on, the plasma is deposited on the surface of the workpiece under the pulsed electric field and the radio frequency electric field.

28. The coating equipment according to claim 26, further comprising at least one electrode configured on one side of the workpiece as a cathode of the pulse power supply to accelerate the positive ions in the plasma to move towards the workpiece.

29. The coating equipment according to claim 28, wherein at least one electrode is configured on the other side of the workpiece as a cathode of the pulse power supply to form the pulsed electric field.

30. The coating equipment according to claim 28, wherein at least one electrode is configured in the reaction chamber body as an anode of the pulse power supply.

31. The coating equipment according to claim 28, further comprising a multi-layered support comprising a plurality of support parts which are configured in the reaction chamber at a preset spacing, wherein the plurality of the workpieces are respectively supported by the plurality of support parts, and the electrode serving as the cathode of the pulse power supply is configured on at least one support part.

32. The coating equipment according to claim 27, further comprising a multi-layered support, comprising a plurality of support parts, wherein the plurality of workpiece are respectively supported by the plurality of support parts, and at least one support part serves as a cathode of the pulse power supply.

33. The coating equipment according to claim 31 or claim 32, wherein at least one support part serves as an electrode of the radio frequency power supply.

34. The coating equipment according to claim 31 or claim 32, wherein at least one support part serves as an anode of the pulse power supply.

35. The coating equipment according to claim 33, wherein the electrode of the radio frequency power supply is configured above a workpiece and the workpiece is supported by a support part serving as the cathode of the pulse power supply.

36. The coating equipment according to claim 34, wherein the support part serving as the anode of the pulse power supply is configured above a workpiece and the workpiece is supported by a support part serving as the cathode of the pulse power supply.

37. The coating equipment according to claim 34, wherein the support part serving as the cathode of the pulse power supply and the support part serving as the anode of the pulse power supply are alternately configured.

38. The coating equipment according to claim 32, wherein at least one layer of the multi-layered support serves as the gas supply part, and the support part serving as the gas supply part is configured above a workpiece.

39. The coating equipment according to claim 38, wherein the support part serving as the gas supply part comprises a top plate and a bottom plate, and a space is configured between the top plate and the bottom plate for temporarily storing gas, and at least one gas outlet is configured on the bottom plate, so that gas can get out of the upper position above the workpiece.

40. The coating equipment according to claim 39, wherein the support part serving as the gas supply part and the support part serving as the cathode of the pulse power supply are alternately configured.

41. The coating equipment according to claim 39, wherein the at least one gas outlet is evenly configured above the workpiece.

42. The coating equipment according to claim 39, wherein the support part serving as the gas supply part is electrically coupled with the radio frequency power supply.

43. The coating equipment according to any one of claim 38 to claim 42, wherein the multi-layered support is configured in the reaction chamber body in a manner of being removable, the multi-layered support further comprises at least two upright posts, and each of the support parts is configured on the at least two upright posts at a preset spacing.

44. The coating equipment according to claim 43, wherein the multi-layered support further comprises at least one insulating part, the insulating part is configured at the bottom end of an upright post to insulate the multi-layered support from the reaction chamber body.

45. The coating equipment according to any one of claim 38 to claim 42, wherein the multi-layered support is detachably supported on the reaction chamber body.

46. The coating equipment according to claim 45, wherein the support parts are configured in the reaction chamber body in parallel with each other.

47. The coating equipment according to any one of claim 26 to claim 32, wherein the coating voltage of the pulse power supply ranges from -300 V to -3500 V, and the frequency of the pulse power supply ranges from 20 KHz to 360 KHz.

48. The coating equipment according to any one of claim 26 to claim 32, wherein the duty ratio of the pulse power supply ranges from 5% to 100%.

49. The coating equipment according to any one of claim 26 to claim 32, wherein the vacuum degree of the coating equipment before coating is controlled to be no more than 2 × 10⁻³Pa.

50. The coating equipment according to any one of claim 26 to claim 32, wherein the vacuum degree of the coating equipment during a coating process ranges from 0.1Pa to 20Pa.

51. A coating equipment for coating at least one workpiece, comprising:
a reaction chamber device provided with a reaction chamber;
a gas supply part configured to supply gas to the reaction chamber;
a pulse power supply adapted to provide the reaction chamber device with a pulsed electric field; and
a support, wherein at least a part of the support is electrically coupled with the pulse power supply as a cathode, wherein the support is adapted to hold the workpiece, and when the pulse power supply is turned on, the gas supplied by the gas supply part for the reaction chamber device generates plasma under the action of ionization, and positive ions in the plasma are deposited toward the surface of the workpiece under the pulsed electric field.

52. The coating equipment according to claim 51, wherein the support comprises a plurality of support parts, wherein each support part is configured in the reaction chamber and at least one support part is electrically coupled with the pulse power supply as a cathode.

53. The coating equipment according to claim 52, wherein each support part is electrically coupled with the pulse power supply as the cathode of the pulse power supply.

54. The coating equipment according to claim 52, wherein at least a part of the reaction chamber device is electrically coupled with the pulse power supply as an anode.

55. The coating equipment according to claim 53 or claim 54, wherein the support further comprises at least one upright post, each support part is respectively supported on the upright post, and the upright post is erected in the reaction chamber.

56. The coating equipment according to claim 55, wherein each support part is respectively electrically coupled with the upright post, and the support part is electrically coupled with the pulse power supply through the upright post.

57. The coating equipment according to claim 56, wherein the support further comprises at least one insulating part, the insulating part is configured at the bottom end of the upright post, and when the support is supported on the reaction chamber device, the support part and the upright post are kept insulated from the reaction chamber device by the insulating part.

58. The coating equipment according to claim 52, wherein at least one support part is electrically coupled with the pulse power supply as an anode.

59. The coating equipment according to claim 58, wherein the support part serving as the anode and the support part serving as the cathode are alternately configured.

60. The coating equipment according to claim 59, wherein a spacing between adjacent a support part serving as anode and a support part serving as cathode is constant.

61. The coating equipment according to any one of claim 58 to claim 60, wherein the support further comprises at least one upright post, each support part is respectively supported on the upright post, and the support part serving as the anode is configured to the upright post in an insulating manner.

62. The coating equipment according to any one of claim 58 to claim 60, wherein the support further comprises at least one upright post, each support part is respectively supported on the upright post, and the support part serving as the cathode is configured to the upright post in an insulating manner.

63. The coating equipment according to any one of claim 58 to claim 60, wherein the support further comprises at least one upright post, each support part is respectively supported on the upright post, and the upright post is made of an insulating material.

64. The coating equipment according to claim 52, further comprising a radio frequency power supply adapted to provide a radio frequency electric field, and the plasma is deposited on the surface of the workpiece under the pulsed electric field and the radio frequency electric field.

65. The coating equipment according to claim 64, wherein at least one support part is electrically coupled with the radio frequency power supply as an electrode of the radio frequency power supply.

66. The coating equipment according to claim 65, wherein the support part serving as the electrode of the radio frequency power supply and the support part serving as the cathode of the pulse power supply are alternately configured.

67. The coating equipment according to claim 64, wherein the support part comprises a first support portion and a second support portion, wherein the first support portion is insulated from and supported on the second support portion, wherein the first support portion is electrically coupled with the pulse power supply as a cathode of the pulse power supply, and the second support portion is electrically coupled with the radio frequency power supply as an electrode of the radio frequency power supply, and the workpiece is held between the second support portion of the support part on one layer of the support and the first support portion of the support part on a next layer of the support.

68. The coating equipment according to claim 52 or claim 53, wherein the distance between the adjacent support parts of the coating equipment is maintained at 10mm ~ 200mm.

69. The coating equipment according to any one of claim 51 to claim 54, wherein the coating temperature of the coating equipment ranges from 25°C to 100°C.

70. The coating equipment according to any one of claim 51 to claim 54, wherein the reaction chamber device is made of stainless steel, and the roughness of the inner surface of the reaction chamber device is less than 0.10 microns.

71. A coating equipment for coating at least one workpiece, comprising:
a reaction chamber device provided with a reaction chamber;
a discharge device configured to provide an electric field to the reaction chamber device;
a gas supply part configured to supply gas to the reaction chamber device; and
a multi-layered support, comprising a plurality of support parts which are configured in the reaction chamber at a preset spacing, at least a part of the gas supply part is configured on at least one support part, and the at least one support part is provided with at least one gas outlet for gas getting out.

72. The coating equipment according to claim 71, wherein one of two adjacent support parts is used for accommodating the workpiece, and the other support part serves as the gas supply part.

73. The coating equipment according to claim 71, wherein at least one support part comprises a first support portion and a second support portion, the first support portion is configured on the second support portion, the second support portion is provided with the at least one gas outlet as the gas supply part, and the first support portion is electrically coupled with the discharge device as a cathode.

74. The coating equipment according to claim 72, wherein the support part serving as the gas supply part comprises a top plate and a bottom plate, and a space is configured between the top plate and the bottom plate for temporarily storing gas, and the at least one gas outlet is configured on the bottom plate.

75. The coating equipment according to claim 74, wherein the at least one gas outlet is evenly configured on the bottom plate of the support part.

76. The coating equipment according to claim 74 or claim 75, wherein the discharge device comprises a pulse power supply, and at least one support part is electrically coupled with the pulse power supply as a cathode of the pulse power supply.

77. The coating equipment according to claim 74 or claim 75, wherein the discharge device comprises a radio frequency power supply, and at least one support part serving as the gas supply part is electrically coupled with the radio frequency power supply as an electrode of the radio frequency power supply.

78. The coating equipment according to claim 76, wherein the discharge device comprises a radio frequency power supply, and at least one support part serving as the gas supply part is electrically coupled with the radio frequency power supply as an electrode of the radio frequency power supply.

79. The coating equipment according to claim 78, wherein the support part which is electrically coupled with the pulse power supply and the support part which is electrically coupled with the radio frequency power supply are alternately configured.

80. The coating equipment according to claim 73, wherein the first support portion comprises a support top plate and a support bottom plate, and a space is configured between the support top plate and the support bottom plate for temporarily storing gas, and the gas outlet is configured on the support bottom plate, and the first support portion is insulated from and supported on the support top plate of the second support portion.

81. The coating equipment according to claim 80, wherein the at least one gas outlet is evenly configured on the support bottom plate of the first support portion.

82. The coating equipment according to claim 80, wherein the first support portion further comprises an insulating part, the insulating part is configured between the support top plate and the support bottom plate of the first support portion to insulate the support top plate of the first support portion from the support bottom plate.

83. The coating equipment according to any one of claim 80 to claim 82, wherein the discharge device comprises a pulse power supply, and the first support portion of the support part is electrically coupled with the pulse power supply as a cathode of the pulse power supply.

84. The coating equipment according to any one of claim 80 to claim 82, wherein the discharge device comprises a radio frequency power supply, and at least one second support portion serving as the gas supply part is electrically coupled with the radio frequency power supply as an electrode of the radio frequency power supply.

85. The coating equipment according to claim 83, wherein the discharge device comprises a radio frequency power supply, and at least one second support portion serving as the gas supply part is electrically coupled with the radio frequency power supply as an electrode of the radio frequency power supply.

86. The coating equipment according to claim 72 or claim 73, wherein the multi-layered support further comprises at least one upright post which is communicably supported by the support part, wherein the support part serving as the gas supply part is communicated with the upright post, and the gas is supplied toward the support part through the upright post.

87. The coating equipment according to claim 72 or claim 73, wherein the multi-layered support further comprises at least one upright post, the support part is configured on the upright post in stacked layers, and the support part is electrically coupled with the upright post.

88. The coating equipment according to any one of claim 71 to claim 75, wherein the distance between adjacent two support parts ranges from 10mm to 200mm.

89. The coating equipment according to claim 73, claim 74 or claim 80, wherein the diameter of the gas outlet ranges from 3 mm to 5 mm.

90. The coating equipment according to claim 73, claim 74 or claim 80, wherein the area size of the support part serving as the gas supply part ranges from 500mm × 500mm to 700mm × 700mm.

91. The coating equipment according to any one of claim 71 to claim 75, wherein the flow rate of the reactant gas supplied by the gas supply part ranges from 10 sccm to 200 sccm.

92. The coating equipment according to any one of claim 71 to claim 75, wherein the flow rate of the plasma source gas supplied by the gas supply part ranges from 50 sccm to 500 sccm.
